# EUROPEAN PATENT SPECIFICATION

(11) **EP 3 806 608 B1**
(45) Date of publication and mention of the grant of the patent: **23.08.2023**
(21) Application number: 18921128.7
(22) Date of filing: 28.05.2018
(51) Int. Cl.: H05K 13/02, H05K 13/04

(54) **TAPE FEEDER**
BANDZUFÜHRER
DISPOSITIF D'ALIMENTATION DE BANDE

(43) Date of publication of application: 14.04.2021
(73) Proprietor: Fuji Corporation, Chiryu-shi, Aichi 472-8686 (JP)
(72) Inventor: TANAKA, Keita, Chiryu-shi, Aichi 472-8686 (JP); HOSOI, Norio, Chiryu-shi, Aichi 472-8686 (JP); KUNIHIRO, Tsutomu, Chiryu-shi, Aichi 472-8686 (JP); MURASE, Hiroki, Chiryu-shi, Aichi 472-8686 (JP)
(74) Representative: Grünecker Patent- und Rechtsanwälte PartG mbB
(86) International application number: PCT/JP2018/020424
(87) International publication number: WO 2019/229824

(56) References cited:
- EP-A1- 3 223 593
- WO-A1-2016/079785
- WO-A1-2016/132438
- JP-A- H 104 287
- JP-A- 2008 078 172

## Description

### Technical Field

This specification discloses technology relating to a tape feeder provided with a reel displacement mechanism for holding a reel holder such that the reel holder can be displaced in the width direction of the feeder main body.

### Background Art

In a tape feeder attached to a feeder setting section of a component mounting machine, as described in Patent Literature 1 (International Publication WO2016/079785), in order to save space, the feeder main body is provided with a reel displacement mechanism for holding a reel holder such that the reel holder can be displaced in the width direction of the feeder main body. In this case, when a second tape feeder is being inserted into a slot adjacent to a first tape feeder inserted into a slot of the feeder setting section of the component mounting machine, the front end portion (the end portion of the attachment direction side) of the feeder main body of the second tape feeder comes in contact with the tapered surface of the rear end portion (the end portion of the detachment direction side) of the reel holder of the first tape feeder and the reel holder of the first tape feeder is displaced in the width direction to a position where insertion of the second tape feeder becomes possible. As a result, the space of the feeder setting section of the component mounting machine is utilized effectively, enabling more tape feeders to be attached to the feeder setting section.

### Patent Literature

Patent Literature 1: International Publication WO2016/079785

### Summary of the Invention

### Technical Problem

Since it is necessary to make exchanges when switching components, switching production, and the like, the tape feeder attached to the feeder setting section of the component mounting machine requires a durability that can withstand repeated exchanges. However, when attaching the tape feeder to the feeder setting section of the component mounting machine, since the front end portion of the feeder main body of the tape feeder collides (abuts) against the tapered surface of the rear end portion of the reel holder of an adjacent tape feeder, as the number of times of attaching tape feeders increases, there is a concern that the front end portion of the feeder main body will get worn or damaged, causing the durability of the tape feeder to deteriorate. Therefore, it is necessary to take some measures to increase the durability of the tape feeder.

### Solution to Problem

In order to solve the above problem, a tape feeder, attached to a feeder setting section of a component mounting machine, comprises: a feeder main body; a reel holder configured to load a tape reel on which a component supply tape is wound; a reel displacement mechanism configured to hold the reel holder displaceably in the width direction with respect to the feeder main body; and a bumper section provided so as to protrude in an attachment direction thereof at the end portion (hereinafter referred to as "front end portion") of the attachment direction side of the feeder main body; wherein, when a second tape feeder is being attached next to a first tape feeder attached to the feeder setting section of a component mounting machine, the bumper section of the second tape feeder first comes into contact with the end portion (hereinafter referred to as "rear end portion") of the detachment direction side of the reel holder of the first tape feeder so as to displace the reel holder of the first tape feeder in the width direction, wherein the bumper section is attached to the end portion of the attachment direction side of the feeder main body so as to be exchangeable.

In this configuration, when attaching the second tape feeder next to the first tape feeder attached to the feeder setting section of the component mounting machine, the bumper section of the second tape feeder first comes in contact with the rear end portion of the reel holder of the first tape feeder and displaces the reel holder of the first tape feeder in the width direction thereof, thereby preventing, by way of the bumper section, the front end portion of the feeder main body of the second tape feeder from colliding with the rear end portion of the reel holder of the first tape feeder when attaching a tape feeder to the feeder setting section of a component mounting machine, and thus preventing wear or damage of the front end portion of the feeder main body.

### Brief Description of Drawings

[Fig. 1] Fig. 1 is a perspective view of a tape feeder of an embodiment.
[Fig. 2] Fig. 2 is a side view of the tape feeder.
[Fig. 3] Fig. 3 is a side view of the feeder main body with a reel holder removed.
[Fig. 4] Fig. 4 is a side view of the reel holder.
[Fig. 5] Fig. 5 is a cross-sectional view showing an upper slide mechanism if Fig. 2 were cut along V-V and viewed from below.
[Fig. 6] Fig. 6 is a cross-sectional view showing a lower slide mechanism if Fig. 2 were cut along VI-VI and viewed from below.
[Fig. 7] Fig. 7 is an enlarged perspective view of the bumper section.

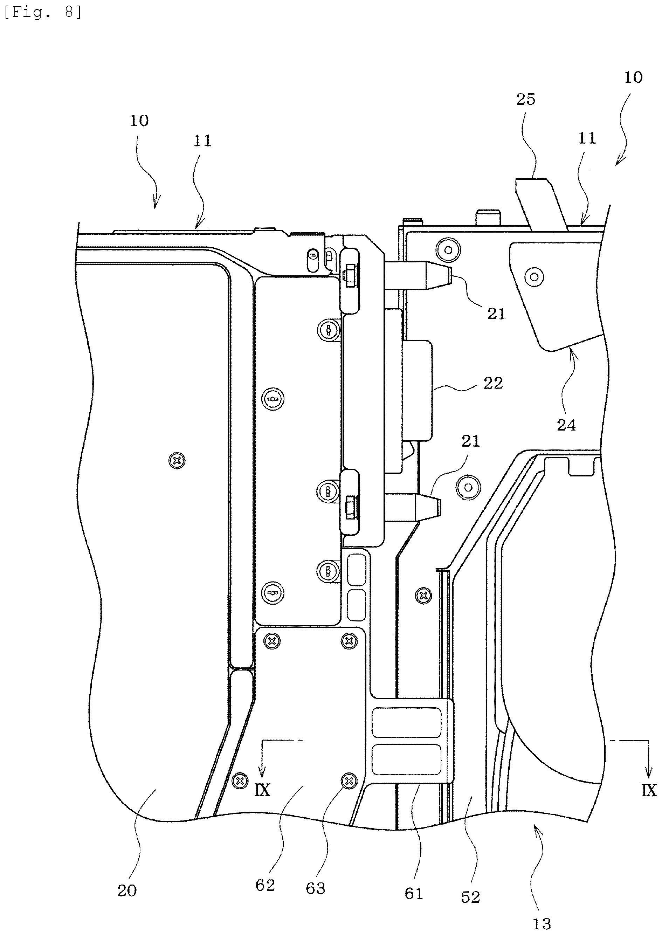

[Fig. 8] Fig. 8 is a side view of a main part showing a state in which the bumper section of a second tape feeder first comes into contact with the rear end portion of a reel holder of a first tape feeder when the second tape feeder is being attached next to the first tape feeder attached to a feeder setting section of a component mounting machine.
[Fig. 9] Fig. 9 is a cross-sectional view taken along IX-IX line of Fig. 8.
[Fig. 10] Fig. 10 is a longitudinal front view showing an enlargement of a holding structure of the upper end face side of the tape feeder set in the feeder setting section of the component mounting machine.
[Fig. 11] Fig. 11 is a partial cutaway side view showing an enlargement of a clamping structure of the upper end face side of the tape feeder set in the feeder setting section of the component mounting machine.

### Description of Embodiments

Hereinafter, an embodiment disclosed in the present specification will be described. First, the configuration of the entire tape feeder 10 will be described.

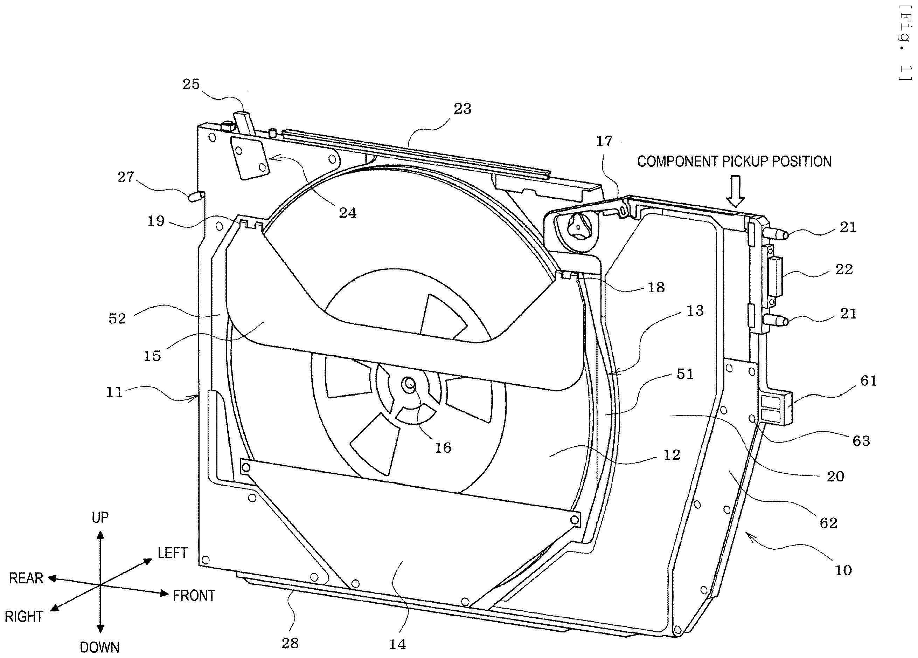

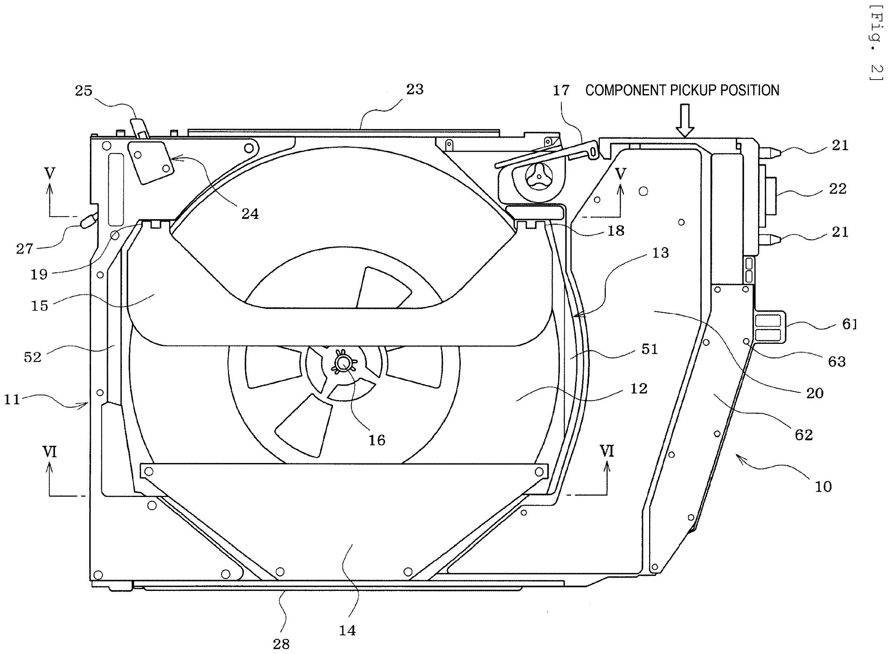

As shown in Figs. 1 and 2, feeder main body 11 of tape feeder 10 has a flat case shape. In feeder main body 11, reel holder 13 for loading tape reel 12 in a rotatable manner is provided such that reel holder 13 can be displaced in the width direction of reel holder 13 (left-right direction) via a reel displacement mechanism to be described later (slide mechanisms 41,42), tape reel 12 being wound with component supply tape (not shown). Lower reel cover 14 for covering the lower part of tape reel 12 is provided to the lower part of reel holder 13. The upper part of reel holder 13 is provided with upper reel cover 15 for covering the upper part of tape reel 12, accommodated in lower reel cover 14, such that upper reel cover 15 can be opened and closed in a rotational manner with hinges 18, 19 on both sides of the upper end serving as a fulcrum.

When taking out tape reel 12 from reel holder 13, upper reel cover 15 is rotated upward with hinges 18, 19 on both sides of the upper end serving as a fulcrum, opening up the upper side of reel holder 13 and enabling a hand to grip the upper side of tape reel 12 in reel holder 13 and pull out tape reel 12 in a tilted upward direction by tilting tape reel 12 away from feeder main body 11. When loading tape reel 12 into reel holder 13, in reel holder 13 with upper reel cover 15 opened, loading of tape reel 12 into reel holder 13 is completed by inserting the lower side of tape reel 12 obliquely from above into lower reel cover 14 and closing upper reel cover 15. The closed state of upper reel cover 15 is maintained with a magnet, spring, or the like.

In this case, a short reel holding shaft (not shown) fitted into central hole 16 of tape reel 12 in the center of reel holder 13 may be provided, and tape reel 12 may be supported by the short reel holding shaft in a rotatable manner. When employing this configuration, it is preferable for the length of reel holding shaft fitted into central hole 16 of tape reel 12 to be shorter than the length of central hole 16 (e.g., 1/2 to 1/3 length) of tape reel 12 so that the reel holding shaft does not inhibit the detachability of tape reel 12. Alternatively, a configuration may be adopted in which multiple rollers (not shown) are provided at the lower side of reel holder 13 (inside lower reel cover 14) along the outer periphery of tape reel 12, and the outer periphery of tape reel 12 may be received and supported in a rotatable manner by the multiple rollers.

Within the upper end face of feeder main body 11, a component pickup position for picking up components with a suction nozzle of a component mounting machine (not shown) is set at a position close to the end face of the attachment direction side (the front side) of feeder main body 11. Tape guide 17 for guiding the component supply tape drawn from tape reel 12 to the component pickup position is provided below the upper end face of feeder main body 11.

Within feeder main body 11, the space between the end face of the attachment direction side of reel holder 13 and feeder main body 11 (front side) is electrical component housing space 20. Electrical component housing space 20 accommodates various electrical components such as a tape feeding device (not shown), for pitch feeding component supply tape to the component pickup position by drawing the component supply tape from tape reel 12 in reel holder 13, and a control section (not shown), for controlling the pitch feeding operation.

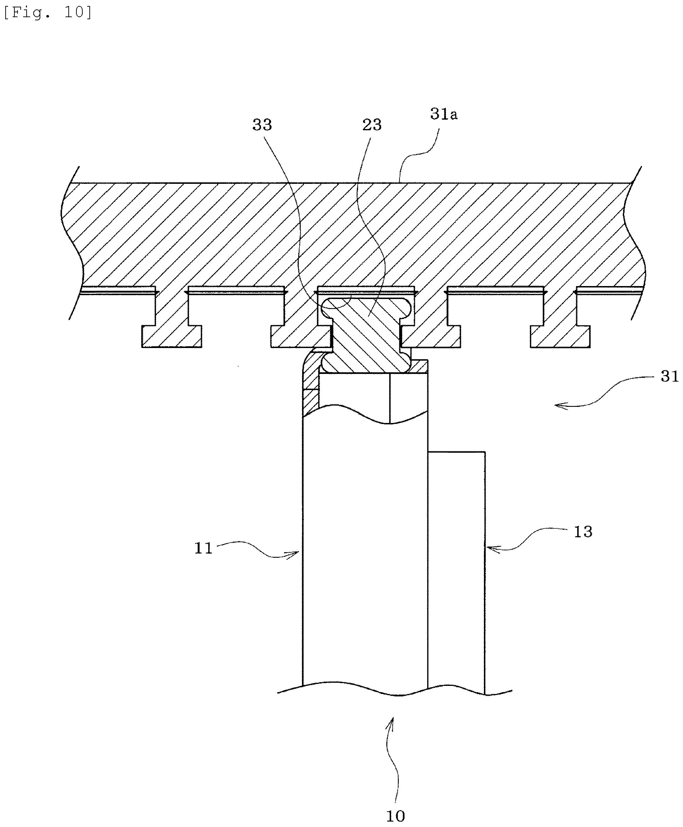

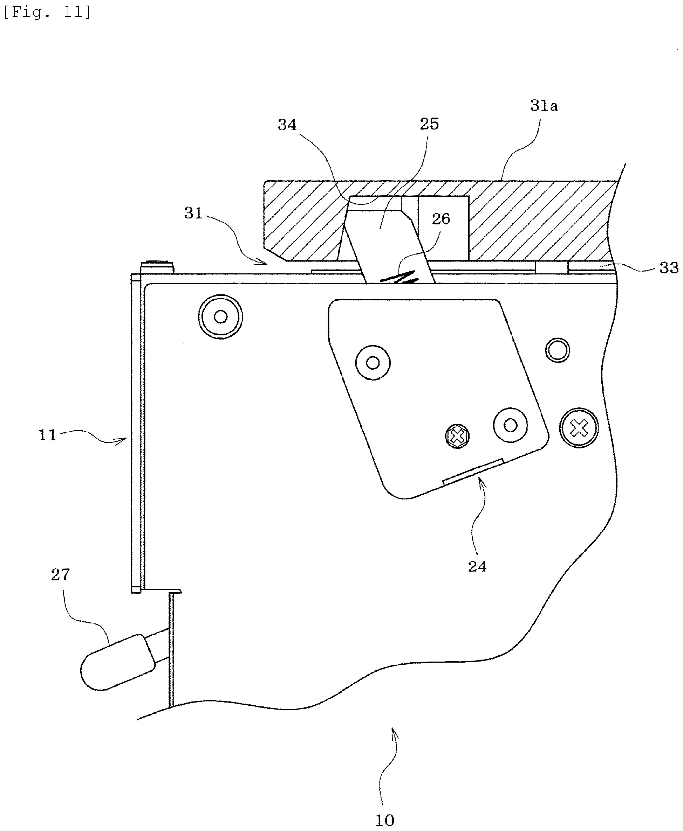

Within the end face of the attachment direction side of feeder main body 11 (front side), two positioning pins 21, 21 (positioning portions) for positioning with respect to feeder setting section 31 (refer to Figs. 10 and 11) of the component mounting machine are provided spaced apart by a predetermined spacing at positions higher than the center in the height direction (in this embodiment, positions close to the upper end face of feeder main body 11). Between these two positioning pins 21,21, connector 22 for supplying power and communication is provided, and by inserting and connecting connector 22 of feeder main body 11 to the connector of the component mounting device side (not shown), power is supplied from the component mounting machine side to various electrical components such as the tape feeder and the control section in feeder main body 11, and various signals such as control signals and sensor signals are transmitted and received between the control section (not shown) of the component mounting machine and the control section of feeder main body 11.

Next, a configuration for holding the state of feeder main body 11 attached to feeder setting section 31 of the component mounting machine will be described.

As shown in Figs. 1 and 2, within the upper end face of feeder main body 11, guide rail 23 having a T-shaped cross section is provided, as an upper holding member, to the upper side of reel holder 13 so as to extend in the attachment/detachment direction of feeder main body 11 (front-rear direction). Correspondingly, as shown in Figs. 10 and 11, member 31a of the upper side of feeder setting section 31 of the component mounting machine is provided with slot groove 33 so as to extend in the attachment/detachment direction of feeder main body 11, slot groove 33 having a T-shaped cross section which fits guide rail 23 of feeder main body 11 having a T-shaped cross section and slidable in the attachment/detachment direction of feeder main body 11, and by guide rail 23 of feeder main body 11 having the T-shaped cross section fitting into slot groove 33 of feeder setting section 31 having the T-shaped cross section, sliding movement in the attachment/detachment direction of feeder main body 11 is guided and held in a state in which pulling off of feeder main body 11 downward is barred. As shown in Fig. 10, member 31a of the upper side of feeder setting section 31, multiple slot grooves 33 are provided at predetermined intervals such that multiple tape feeders 10 can be set side by side in the left-right direction in feeder setting section 31.

In addition, clamping device 24 (refer to Fig. 11), which is configured to clamp feeder main body 11 while feeder main body 11 is attached to feeder setting section 31 of the component mounting machine, is provided on the upper end face of feeder main body 11 at a position near the end face (rear side) in the detachment direction of feeder main body 11. This clamping device 24 includes clamp member 25, which projects obliquely upward from the upper end face of feeder main body 11 when clamping, spring 26 such as a spring for biasing clamp member 25 obliquely upward which is the direction for clamping, and operation lever 27, which operates a clamp releasing operation in which clamp member 25 is retracted obliquely downward, which is a clamp releasing direction. Operation lever 27 is disposed so as to protrude from the end face of the detachment direction side of feeder main body 11 (rear side).

On the other hand, as shown in Fig. 11, within the upper side of feeder setting section 31 of the component mounting machine, clamp hole 34 is provided at a position corresponding to clamp member 25, and by way of clamp member 25 fitting into clamp hole 34, feeder main body 11 is clamped in an attached state. In this case, by clamp member 25 being pushed up by spring 26 obliquely upward in the detachment direction side of feeder main body 11 (rear side), the upper end portion of clamp member 25 presses against the side face in the feeder main body 11 detachment direction side of clamp hole 34 (rear side), and in reaction, feeder main body 11 is pushed in the attachment direction of feeder main body 11 thereby causing feeder main body 11 to be accurately positioned and connector 22 to be held in a connected state.

As shown in Figs. 1 and 2, the lower end face of feeder main body 11 is provided with guide rail 28, having an I-shaped cross section, as a lower holding member, so as to extend in the attachment/detachment direction of feeder main body 11. Correspondingly, a member (not shown) of the lower side of feeder setting section 31 of the component mounting machine is provided with a rail groove (not shown) so as to extend in the attachment/detachment direction, the rail groove having an I-shaped cross section which fits guide rail 28 of feeder main body 11 having an I-shaped cross section and slidable in the attachment/detachment direction of feeder main body 11, and by guide rail 28 of feeder main body 11 having the I-shaped cross section fitting into rail groove of the lower side of feeder setting section 31 having the I-shaped cross section, sliding movement in the attachment/detachment direction of feeder main body 11 is guided and held in a state in which pulling off of feeder main body 11 upward is barred. With this, even if the manufacturing variation in the height of feeder setting section 31 of the component mounting machine or the manufacturing variation in height of feeder main body 11 increases to some extent, the frictional resistance force during sliding movements of feeder main body 11 in the attachment/detachment direction can be prevented from increasing, thereby enabling attachment/detachment of feeder main body 11 to be performed smoothly.

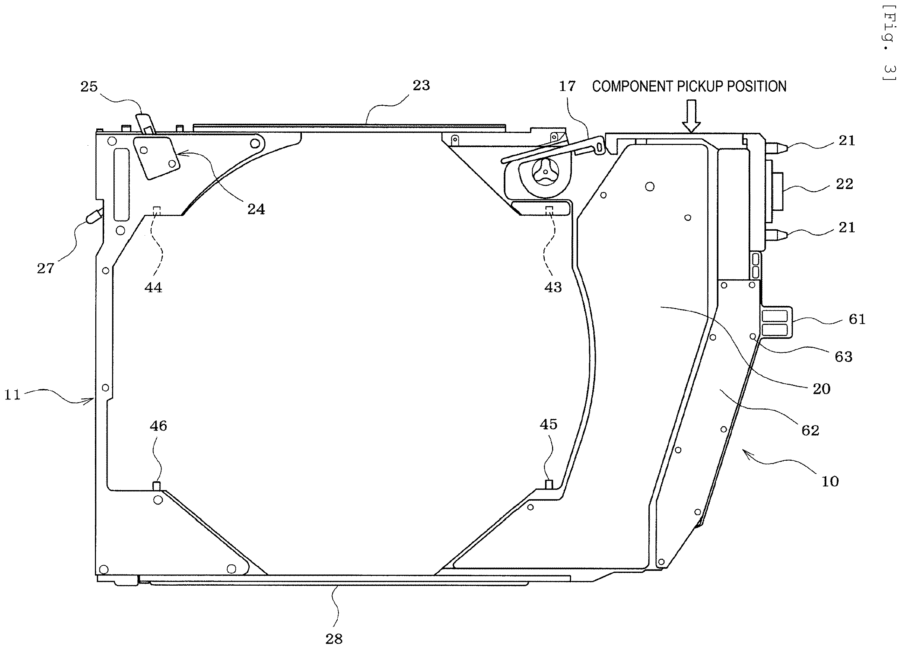

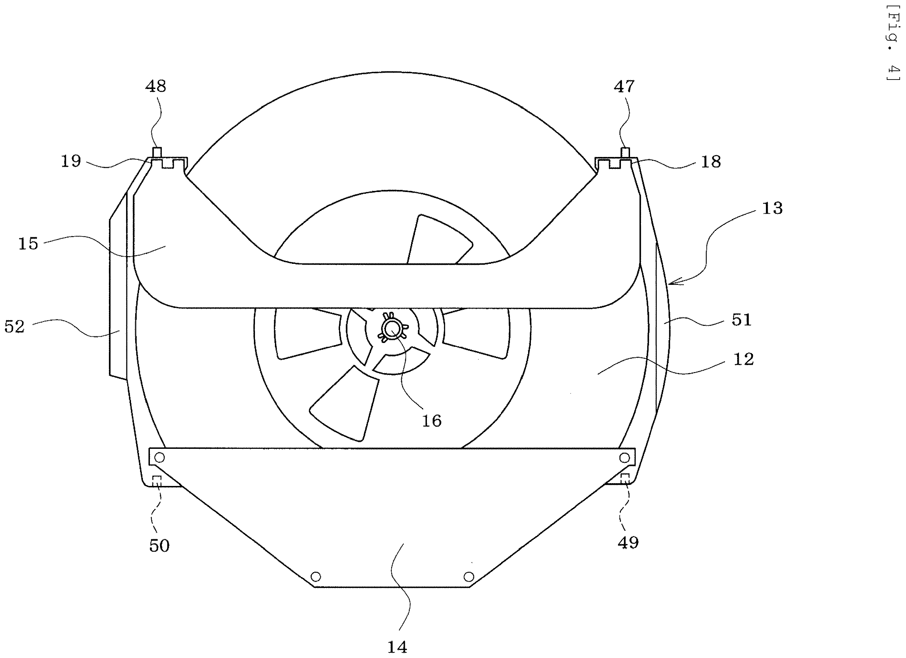

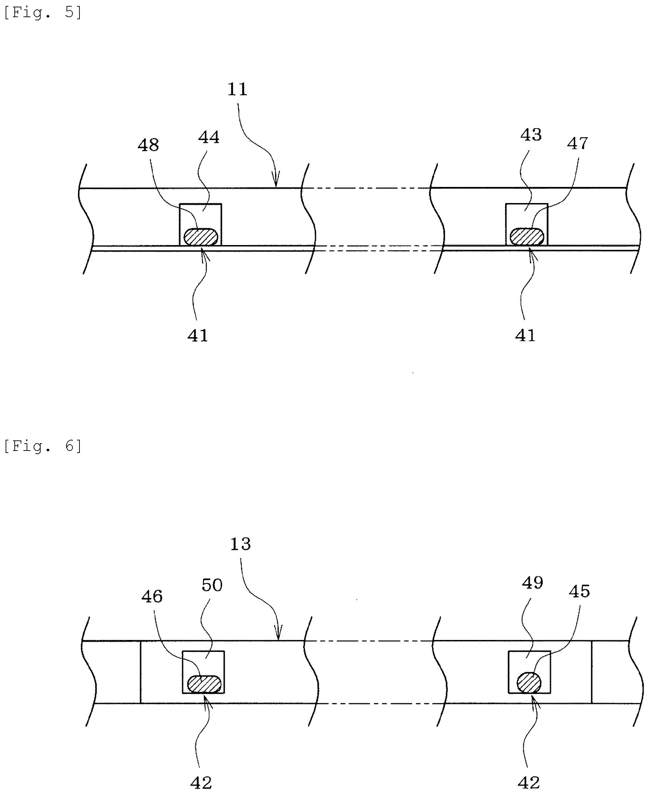

Next, a configuration will be described of the reel displacement mechanism for holding reel holder 13 with respect to feeder main body 11 such that reel holder 13 can be displaced in the width direction (left-right direction). The reel displacement mechanism may be configured using a link mechanism as in Patent Literature 1, but in the present embodiment, the reel displacement mechanism is configured using slide mechanisms 41,42 shown in Figs. 5 and 6. Slide mechanisms 41,42 are configured with upper slide grooves 43,44 provided so as to open downward at the front and rear sides of the upper portion of feeder main body 11 (refer to Figs. 3 and 5), lower protrusions 45,46 provided so as to protrude upward on both front and rear sides of the lower portion of feeder main body 11 (refer to Figs. 3 and 6), upper protrusions 47,48 provided so as to protrude upward on both front and rear sides of the upper portion of reel holder 13 (refer to Figs. 4 and 5), and lower slide grooves 49,50 provided so as to open downward on both front and rear sides of the lower portion of reel holder 13 (refer to Figs. 4 and 6). As shown in Fig. 5, as a result of upper protrusions 47,48 of reel holder 13 slidably fitting into upper slide grooves 43,44 of feeder main body 11 in the width direction (left-right direction) of feeder main body 11 and, as shown in Fig. 6, lower slide grooves 49,50 of reel holder 13 slidably fitting lower protrusions 45,46 of feeder main body 11 in the width direction (left-right direction) of feeder main body 11, reel holder 13 is held with respect to feeder main body 11 such that reel holder 13 can be displaced in the width direction (left-right direction) with respect to feeder main body 11.

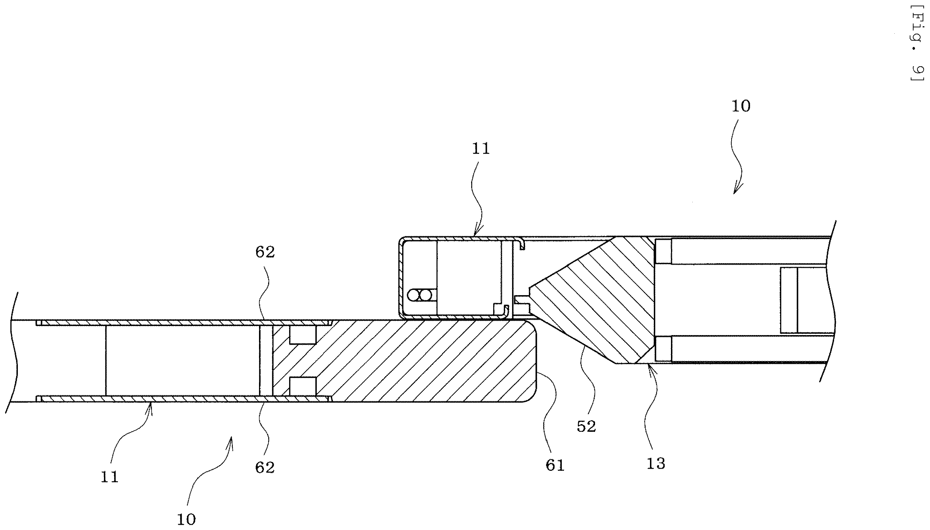

As shown in Figs. 4 and 9, tapered surfaces 51,52, having a substantially triangular horizontal cross section, are provided at both end portions in the front-rear direction (attachment/detachment direction of tape feeder 10) of reel holder 13 so as to allow reel holder 13 to smoothly slide in the width direction thereof. The width of feeder main body 11 is set slightly smaller than the interval or pitch at which slot grooves 33 are formed in feeder setting section 31, whereas as shown in Fig. 9, the width of reel holder 13 is set larger than the width of feeder main body 11 (larger than the pitch at which slot grooves 33 are formed in feeder setting section 31) and at a width no wider than 1.5 times the pitch at which slot grooves 33 are formed. Thus, when attaching feeder main body 11 into slot groove 33 of feeder setting section 31, reel holder 13 protrudes from feeder main body 11 to the adjacent slot groove 33 side, and the protruding amount is set to be less than half the pitch of slot groove 33.

Incidentally, when attaching tape feeder 10 to feeder setting section 31 of the component mounting machine, and the front end portion of feeder main body 11 of tape feeder 10 collides (abuts) against tapered surface 52 of the rear end portion of reel holder 13 of the adjacent tape feeder 10, there is a concern that the front end portion of feeder main body 11 will get worn, damaged, or disfigured, causing the durability of tape feeder 10 to deteriorate.

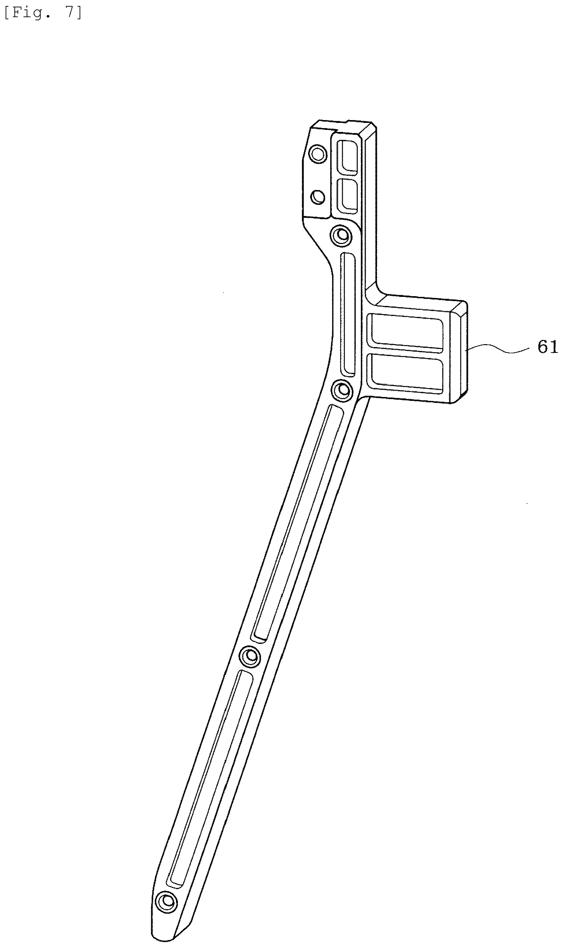

As a countermeasure, in this embodiment, bumper section 61 (refer to Fig. 7), protruding in the attachment direction, is sandwiched between two metal plates 62,62 and attached to the end portion of the attachment direction side of feeder main body 11 (front end portion) by screws 63 or the like in an exchangeable manner. Thus, when attaching a second tape feeder 10 next to a first tape feeder 10 attached to feeder setting section 31 of the component mounting machine, as shown in Fig. 9, bumper section 61 of the second tape feeder 10 is first in contact with the end portion of the detachment direction side of reel holder 13 of the first tape feeder 10 (rear end portion), such as to displace reel holder 13 of the first tape feeder 10 in the width direction. The part of the rear end portion of reel holder 13 that bumper section 61 abuts is formed on tapered surface 52 so that reel holder 13 is easily displaced in the width direction thereof by the contact force. Further, bumper section 61 is made of the same resin material as that of the rear end portion of reel holder 13 or a softer resin material.

With the present embodiment described above, bumper section 61 protruding forward is provided to the front end portion of feeder main body 11 so as to be exchangeable, and when attaching the second tape feeder 10 next to the first tape feeder 10 attached to feeder setting section 31 of the component mounting machine, bumper section 61 of the second tape feeder 10 first comes in contact with the rear end portion of reel holder 13 of the first tape feeder 10 and displaces reel holder 13 of the first tape feeder 10 in the width direction thereof, thereby preventing, by way of bumper section 61, the front end portion of feeder main body 11 of the second tape feeder 10 from colliding with the rear end portion of reel holder 13 of the first tape feeder 10 when attaching tape feeder 10 to feeder setting section 31 of a component mounting machine, and thus preventing wear or damage of the front end portion of feeder main body 11 and increasing the durability of feeder main body 11.

Moreover, since bumper section 61 is exchangeably attached by screws 63 or the like to the front end portion of feeder main body 11, by making bumper section 61 available to the user as an exchangeable component, separately from tape feeder 10, the user can exchange bumper section 61 worn or damaged by long-term use as appropriate with a new exchangeable component.

Further, since bumper section 61 is made of the same resin material as that of the rear end portion of reel holder 13 or a softer resin material, it is possible to reduce the wear and damage of tapered surface 52 of reel holder 13 with which bumper section 61 collides (abuts), thus improving the durability of reel holder 13.

It is needless to say that the present invention is not limited to the above-described embodiment and can be implemented by various modifications within the scope of the appended claims, such as, for example, the shape and attachment structure of bumper section 61 may be appropriately changed, or the configurations of feeder main body 11 and reel holder 13 may be appropriately changed.

### Reference Signs List

10... Tape feeder, 11... Feeder main body, 12... Tape reel, 13... Reel holder, 23... Guide rail, 31... Feeder setting section, 33... Slot groove, 41, 42... Slide mechanisms (reel displacement mechanisms), 43, 44... Upper slide grooves, 45,46... Lower protrusions, 47, 48... Upper protrusions, 49, 50... Lower slide grooves, 51, 52... Tapered surfaces, 61... Bumper section

## Claims

1. A tape feeder (10), attached to a feeder setting section (31) of a component mounting machine, comprising:
a feeder main body (11);
a reel holder (13) configured to load a tape reel (12) on which a component supply tape is wound;
a reel displacement mechanism (41, 42) configured to hold the reel holder (13) displaceably in the width direction with respect to the feeder main body (11); and
a bumper section (61) provided so as to protrude in an attachment direction thereof at the end portion of the attachment direction side of the feeder main body (11);
wherein, when a second tape feeder is being attached next to a first tape feeder attached to a feeder setting section, the bumper section (61) of the second tape feeder first comes into contact with the end portion of the detachment direction side of the reel holder (13) of the first tape feeder so as to displace the reel holder (13) of the first tape feeder in the width direction,
wherein the bumper section (61) is attached to the end portion of the attachment direction side of the feeder main body (11) so as to be exchangeable.

2. The tape feeder of claim 1, wherein the part of the end portion of the detachment direction side of the reel holder (13) that the bumper section (61) comes in contact with is formed on a tapered surface (51, 52) so that the reel holder (13) is easily displaced in the width direction thereof by the contact force.

3. The tape feeder of claim 1 or 2, wherein the bumper section (61) is made of a resin material.

4. The tape feeder of claim 3, wherein the bumper section (61) is made of the same resin material as that of the end portion of the detachment direction side of the reel holder (13) or a softer resin material.

5. The tape feeder of any one of claims 1 to 4, wherein the reel displacement mechanism (41, 42) is configured with a slide mechanism for supporting the reel holder (13) such that the reel holder (13) can slide in the width direction thereof.

## Patentansprüche

1. Band-Transportvorrichtung (10), die an einem Abschnitt (31) zum Anordnen der Transportvorrichtung einer Maschine zum Montieren von Bauteilen angebracht ist, wobei sie umfasst:
einen Hauptkörper (11) der Transportvorrichtung;
einen Spulen-Halter (13), der zum Aufnehmen einer Bandspule (12) ausgeführt ist, auf die ein Bauteil-Zuführband aufgewickelt ist;
einen Spulen-Verschiebemechanismus (41, 42), der so ausgeführt ist, dass er den Spulen-Halter (13) so hält, dass er in der Breitenrichtung in Bezug auf den Hauptkörper (11) der Transportvorrichtung verschoben werden kann; und
einen Dämpferabschnitt (61), der in einer Anbringungsrichtung desselben an dem Endabschnitt an der Seite des Hauptkörpers (11) der Transportvorrichtung in der Anbringungsrichtung vorsteht;
wobei, wenn eine zweite Band-Transportvorrichtung neben einer ersten Band-Transportvorrichtung angebracht wird, die an einem Abschnitt zum Anordnen einer Transportvorrichtung angebracht ist, der Dämpferabschnitt (61) der zweiten Band-Transportvorrichtung zuerst mit dem Endabschnitt an der Seite in der Trennungsrichtung des Spulen-Halters (13) der ersten Band-Transportvorrichtung in Kontakt kommt und den Spulen-Halter (13) der ersten Band-Transportvorrichtung in der Breitenrichtung verschiebt,
wobei der Dämpferabschnitt (61) an dem Endabschnitt an der Seite des Hauptkörpers (11) der Transportvorrichtung in der Anbringungsrichtung so angebracht ist, dass er ausgetauscht werden kann.

2. Band-Transportvorrichtung nach Anspruch 1, wobei der Teil des Endabschnitts an der Seite des Spulen-Halters (13) in der Trennungsrichtung, mit dem der Dämpferabschnitt (61) in Kontakt kommt, an einer sich verjüngenden Fläche (51, 52) so ausgebildet ist, dass der Spulen-Halter (13) durch die Kontaktkraft leicht in seiner Breitenrichtung verschoben wird.

3. Band-Transportvorrichtung nach Anspruch 1 oder 2, wobei der Dämpferabschnitt (61) aus einem Harzmaterial besteht.

4. Band-Transportvorrichtung nach Anspruch 3, wobei der Dämpferabschnitt (61) aus dem gleichen Harzmaterial wie dem des Endabschnitts der Seite des Spulen-Halters (13) in der Ablöserichtung oder einem weicheren Harzmaterial besteht.

5. Band-Transportvorrichtung nach einem der Ansprüche 1 bis 4, wobei der Spulen-Verschiebemechanismus (41, 42) mit einem Gleitmechanismus ausgeführt ist, der den Spulen-Halter (13) so trägt, dass der Spulen-Halter (13) in seiner Breitenrichtung gleiten kann.

## Revendications

1. Chargeur de bande (10), attaché à une section de configuration de chargeur (31) d'une machine de montage de composants, comprenant :
un corps principal de chargeur (11) ;
un support de bobine (13) configuré pour charger une bobine de bande (12) sur laquelle une bande d'alimentation en composants est enroulée ;
un mécanisme de déplacement de bobine (41, 42) configuré pour maintenir le support de bobine (13) en mobilité dans la direction de largeur par rapport au corps principal de chargeur (11) ; et
une section d'amortissement (61) disposée de sorte à déborder dans une direction de rattachement de celle-ci sur la partie d'extrémité du côté de direction de rattachement du corps principal de chargeur (11) ;
dans lequel, lorsqu'un deuxième chargeur de bande est rattaché à côté d'un premier chargeur de bande rattaché à une section de configuration de chargeur, la section d'amortissement (61) du deuxième chargeur de bande entre d'abord en contact avec la partie d'extrémité du côté de direction de détachement du support de bobine (13) du premier chargeur de bande de sorte à déplacer le support de bobine (13) du premier chargeur de bande dans la direction de largeur,
dans lequel la section d'amortissement (61) est rattachée à la partie d'extrémité du côté de direction de rattachement du corps principal de chargeur (11) de sorte à être échangeable.

2. Le chargeur de bande de la revendication 1, dans lequel la partie de la partie d'extrémité du côté de direction de détachement du support de bobine (13) avec laquelle la section d'amortissement (61) entre en contact est constituée sur une surface biseautée (51, 52) de sorte que le support de bobine (13) soit facilement déplacé dans la direction de largeur de celle-ci par la force de contact.

3. Le chargeur de bande de la revendication 1 ou 2, dans lequel la section d'amortissement (61) est constituée d'un matériau résineux.

4. Le chargeur de bande de la revendication 3, dans lequel la section d'amortissement (61) est faite du même matériau résineux que celui de la partie d'extrémité du côté de direction de détachement du support de bobine (13) ou d'un matériau résineux plus tendre.

5. Le chargeur de bande de l'une quelconque des revendications 1 à 4, dans lequel le mécanisme de déplacement de bobine (41, 42) est configuré avec un mécanisme de coulissement pour soutenir le support de bobine (13) de sorte que le support de bobine (13) puisse coulisser dans la direction de largeur de celui-ci .
